# EUROPEAN PATENT APPLICATION

(11) **EP 2 690 418 A1**
(43) Date of publication of application: **29.01.2014**
(21) Application number: 12177738.7
(22) Date of filing: 24.07.2012
(51) Int. Cl.: G01L 9/00, H01L 29/84

(54) **Pressure sensor having flexible diaphragm with active circuit components thereon**

(71) Applicant: Honeywell International Inc., Morristown, NJ 07962-2245 (US)
(72) Inventor: Dumitru, Viorel Georgel, 100077 Prahova (RO); Costea, Stefan Dan, 041444 Bucharest (RO); Brezeanu, Mihai, 061397 Bucharest (RO)
(74) Representative: Houghton, Mark Phillip

(57) **Abstract**

A pressure sensor (100) includes a substrate (105) having a flexible diaphragm (107), and a differential amplifier including two or more transistors (110, 120, 130, 140) formed on the flexible diaphragm. Each of the two or more transistors may include a gate (112), a source (114) and a drain (116). In some cases, each of the two or more transistors may include a semiconductor layer and a piezoelectric layer, wherein the piezoelectric layer modulates an electric charge on the gate of the corresponding transistor based on the deflection of the flexible diaphragm. The electric charge may modulate the current that is passing through the corresponding transistors, which may cause the differential amplifier to produce an output that is representative of the applied input pressure.

## Description

### TECHNICAL FIELD

The present disclosure relates generally to pressure sensors.

### BACKGROUND

Pressure sensors are used in a wide variety of applications including, for example, commercial, automotive, aerospace, industrial, and medical applications. Pressure measurements are typically taken in the context of absolute, gauge, or differential (or relative) pressure. An absolute pressure sensor typically represents a specific type of sensing device, which measures a pressure relative to a vacuum (or near vacuum). A gauge pressure sensor typically measures a pressure relative to atmospheric pressure. A differential pressure sensor typically measures a pressure difference between two inputs.

Pressure sensors often include a pressure sensitive diaphragm that flexes or bends in response to an applied input pressure. In some cases, piezoresistive elements, often connected in a Wheatstone bridge configuration, are placed on the pressure sensitive diaphragm. When an input pressure is applied, the diaphragm deforms and the resistance of the piezoresistive elements changes accordingly. An output of the Wheatstone bridge is often used to provide a measure that is related to the applied input pressure.

### SUMMARY

The present disclosure relates generally to pressure sensors, and more particularly, to pressure sensors that have a flexible diaphragm with one or more active circuit components on the flexible diaphragm. In an illustrative embodiment, a pressure sensor may include a substrate having a flexible diaphragm, and a differential amplifier including two or more transistors formed on the flexible diaphragm. Each of the two or more transistors may include a gate, a source and a drain. In some cases, each of the two or more transistors may include a semiconductor layer and a piezoelectric layer, wherein the piezoelectric layer modulates an electric charge on the gate of the corresponding transistor. The electric charge may be related to an input pressure applied to the flexible diaphragm. In some cases, the piezoelectric layer may include at least one of aluminum nitride (AlN), zinc oxide (ZnO), lead zirconate titanate (PZT), barium titanate (BaTiO3), polyvinylidene fluoride (PVDF), a ceramic, or any other suitable piezoelectric layer as desired.

In some cases, the two or more transistors may be high hole mobility transistors (HHMTs) that include a semiconductor layer of diamond. In other cases, the two or more transistors may be metal-oxide-semiconductor field-effect transistors (MOSFETs) that include a semiconductor layer that includes at least one of silicon (Si), silicon carbide (SiC), silicon on insulator (SOI), diamond, gallium nitride (GaN), and gallium arsenide (GaAs). In some cases, the two or more transistors may be high electron mobility transistors (HEMTs) that include a semiconductor layer of gallium nitride (GaN). In some cases, the two or more transistors may be organic field effect transistors (OFETs) that include a semiconductor layer of an organic material, wherein the organic material may include, for example, at least one of rubrene, tetracene, pentacene, diindenoperylene, perylenediimides, tetracyanoquinodimethane (TCNQ), polythiophene, polyfluorene, polydiacetylene, poly 2,5-thienylene vinylene, or poly p-phenylene vinylene (PPV). In some cases, the two or more transistors may be thin film transistors (TFTs) including a semiconductor layer having at least one of Zinc oxide (ZnO), Indium gallium zinc oxide (InGaZnO), polycristaline silicon, amorphous silicon, hydrogenated amorphous silicon (a-Si:H), microcrystalline silicon, or polysilicon. In some cases, the two or more transistors may include nanowire (NW)-FETs having a piezoelectric layer. In some cases, the nanowire may include at least one of a carbon nanotube or a germanium and silicon nanowire. These are just some examples.

The preceding summary is provided to facilitate an understanding of some of the innovative features unique to the present disclosure and is not intended to be a full description. A full appreciation of the disclosure can be gained by taking the entire specification, claims, drawings, and abstract as a whole.

### BRIEF DESCRIPTION

The disclosure may be more completely understood in consideration of the following description of various illustrative embodiments in connection with the accompanying drawings, in which:
Figures 1A and 1B show cross-sectional side views of an illustrative pressure sense die having transistors formed over a flexible diaphragm, which is in fluid communication with an open cavity;
Figures 2A and 2B show cross-sectional side views of another illustrative pressure sense die having transistors formed over a flexible diaphragm, which is in fluid communication with a sealed cavity;
Figure 3 shows a schematic diagram of an illustrative pressure sensitive differential amplifier circuit that may be formed on the pressure sense die of Figures 1A, 1B, 2A, and 2B;
Figure 4 is a schematic top view of an illustrative sense die of Figures 1A, 1B, 2A, and 2B;
Figures 5A and 5B show illustrative transistor structures formed on a diamond substrate that may be used in the illustrative sense die of Figures 1A, 1B, 2A, 2B, and 4;
Figures 6A and 6B show illustrative metal-oxide-semiconductor field effect transistor (MOSFET) structures formed on a semiconductor substrate that may be used in the illustrative sense dies of Figures 1A, 1B, 2A, 2B, and 4;
Figures 6C and 6D show illustrative metal semiconductor field effect transistor (MESFET) transistor structures formed on a semiconductor substrate that may be used in the illustrative sense dies of Figures 1A, 1B, 2A, 2B, and 4;
Figures 7A and 7B show illustrative metal-oxide-semiconductor field effect transistor (MOSFET) structures formed on a silicon-on-insulator (SOI) substrate that may be used in the illustrative sense dies of Figures 1A, 1B, 2A, 2B, and 4;
Figures 8A and 8B show illustrative metal-oxide-semiconductor field effect transistor (MOSFET) structures formed on a silicon carbide (SiC) substrate that may be used in the illustrative sense dies of Figures 1A, 1B, 2A, 2B, and 4;
Figures 9A and 9B show illustrative high electron mobility transistors (HEMTs) based on gallium nitride (GaN) that may be used in the illustrative sense die of Figures 1A, 1B, 2A, 2B, and 4;
Figures 10A and 10B show illustrative thin-film high transistors (TFTs) that may be used in the illustrative sense die of Figures 1A, 1B, 2A, 2B, and 4;
Figures 11A and 11B show illustrative nanowire transistors (NWTs) that may be used in the illustrative sense die of Figures 1A, 1B, 2A, 2B, and 4;
Figure 11C shows a cross-sectional view of an illustrative nanowire used in the nanowire transistors of Figures 11A and 11B;
Figure 12A shows a cross-sectional side view of an illustrative pressure sensor including the illustrative sense die of Figures 1A, 1B, 2A, 2B and 4;
Figure 12B shows a package view of the illustrative pressure sensor of Figure 12A;
Figure 12C shows another package view of the illustrative pressure sensor of Figure 12A; and
Figure 13 shows an illustrative technique for manufacturing a pressure sensor.

While the disclosure is amenable to various modifications and alternative forms, specifics thereof have been shown by way of example in the drawings and will be described in detail. It should be understood, however, that the intention is not to limit aspects of the disclosure to the particular illustrative embodiments described herein. On the contrary, the intention is to cover all modifications, equivalents, and alternatives falling within the spirit and scope of the disclosure. Also, it is contemplated that features from one of the illustrative embodiments may be combined with features from other illustrative embodiments, as desired.

### DESCRIPTION

The following description should be read with reference to the drawings wherein like reference numerals indicate like elements throughout the several views. The description and drawings show several examples which are meant to be illustrative in nature.

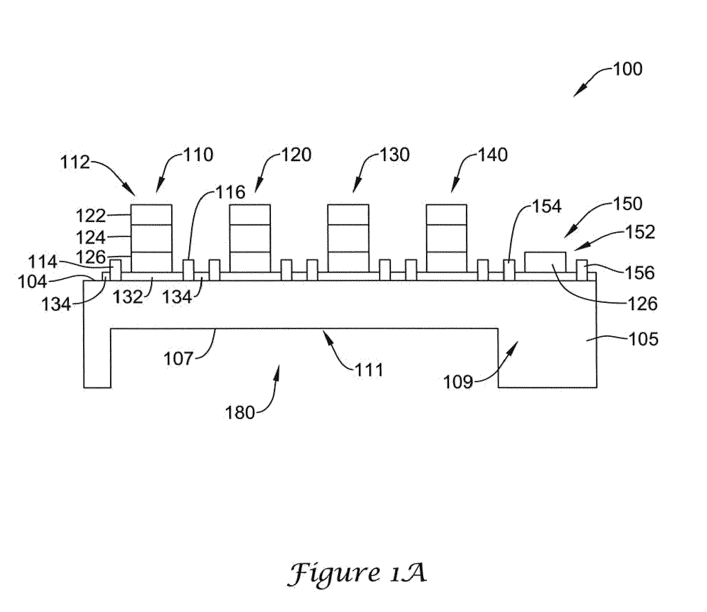

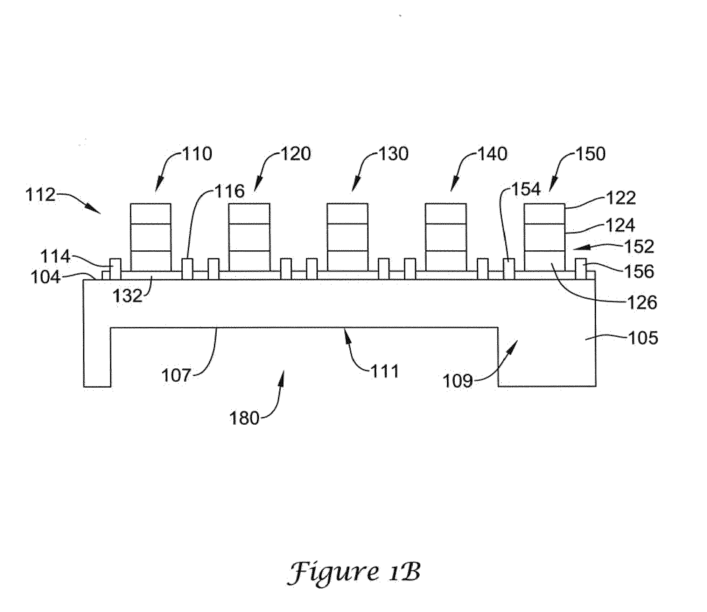

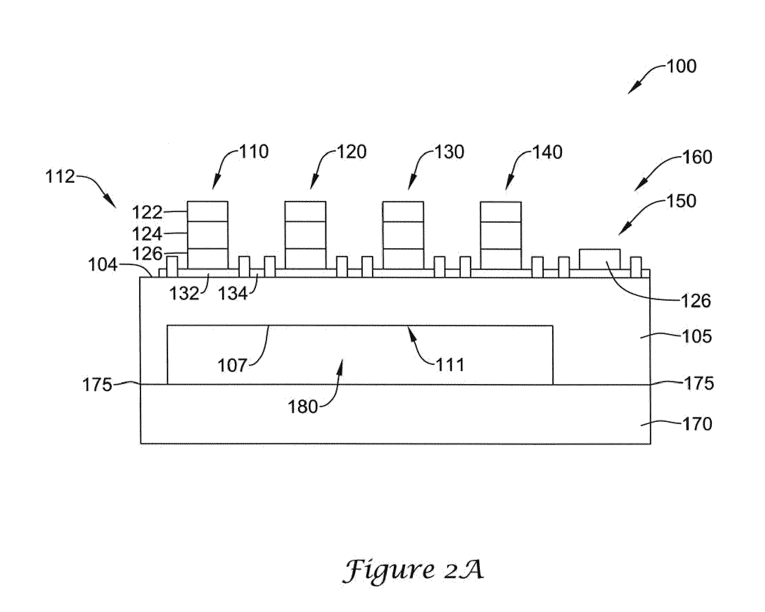

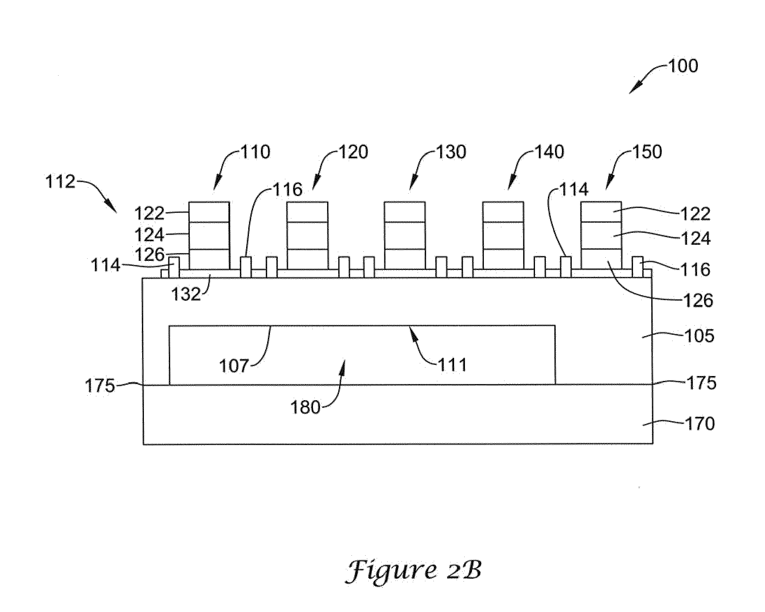

Figures 1A, 1B, 2A, and 2B show cross sectional views of illustrative pressure sense die 100, 160 having transistors formed over and supported by a flexible diaphragm 107. In an illustrative embodiment, a pressure sense die, such as the pressure sense dies 100 and 160, may be created by forming one or more transistors 110, 120, 130, 140, 150 on a surface 104 of a substrate 105. Each transistor 110, 120, 130, 140, 150 includes a gate 112, a source 114, and a drain 116, where each transistor may be electrically separated from other circuit components by an insulator 134. The gates of the transistors may include one or more layers, such as an insulator layer 132, which may be the same or different from the insulator 134, one or more metal layers 122, 126 and a piezoelectric layer 124. In some cases, a transistor located over an area 109 of the substrate laterally adjacent to the diaphragm 107, such as transistor 150, may include a metal layer 126 with or without a piezoelectric layer. In some cases, the transistors 110, 120, 130, 140, 150 may be connected to form an electrical circuit (e.g., a pressure sensitive differential amplifier circuit), which may be configured to sense an input pressure applied to the sense die. A portion of the electrical circuit (e.g., transistors 110, 120, 130, and 140) may be located above and may be supported by a flexible membrane and/or diaphragm 107, sometimes formed by the substrate. The electric circuit may be configured to sense an input pressure applied to the sense die 100, 160 as the diaphragm 107 deforms due to the applied input pressure. Another portion of the electrical circuit (e.g., transistor 150) may be formed above an area 109 of the substrate 105 that does not deform, such as the thicker substrate region that is laterally adjacent to the thinner diaphragm 107.

In some cases, the sense dies 100, 160 may be formed using a substrate 105, wherein the substrate 105 may include one or more materials, such as silicon, Germanium, diamond, silicon carbide (SiC), gallium nitride (GaN), gallium arsenide (GaAs), diamond, sapphire, indium phosphide (InP) and/or the like. In some cases, the substrate may be formed in layers. For example, the substrate may include a first layer of a first material (e.g., a semiconductor, an insulator, etc.), upon which a second semiconductor layer may be deposited, grown, or otherwise formed. For example, a diamond substrate may be formed using a high-pressure high-temperature synthesis (HPHT) process to provide a substrate known as HPHT diamond, upon which a diamond semiconductor layer may be a single crystal diamond formed by chemical vapor deposition (CVD). In another example, silicon on insulator (SOI) substrate, a silicon on Sapphire (SOS) or another suitable substrate may be used, as desired. In another example AlGaN/GaN heterostructures grown on sapphire, SiC or Si may be used. In other cases, such as for thin film transistors (TFTs), other materials may be used as substrates, such as glass, plastic, stainless steel, molybdenum, and the like, upon which a thin film of a semiconductor material may be deposited, grown or otherwise formed (e.g., amorphous silicon (a-Si:H), polycrystalline silicon, ZnO, etc.).

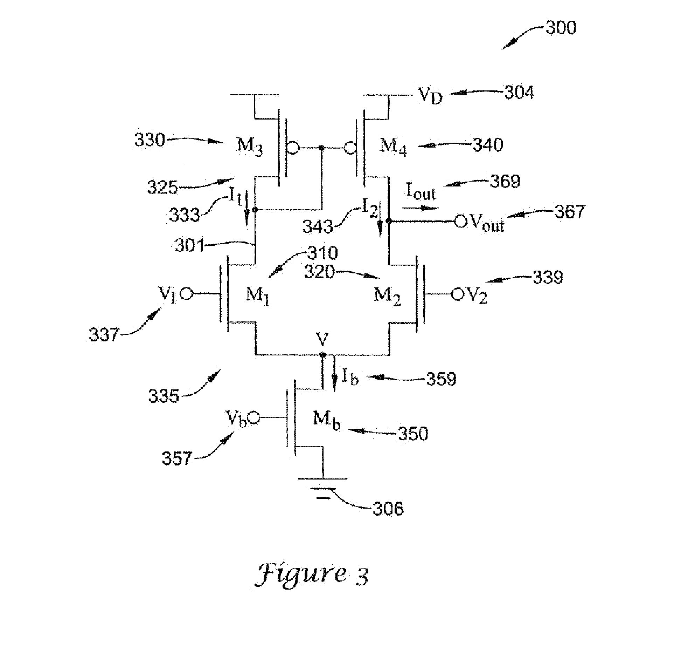

The substrate 105 may be processed using one or more semiconductor fabrication techniques to form electrical components, such as transistors 110, 120, 130, 140, 150 and one or more electrical pathways (e.g., electrical pathway 301 of Figure 3) above the surface 104 of the substrate 105. The transistors 110, 120, 130, 140, 150 and/or other electrical components may be connected by the electrical pathways (i.e. traces) to form an electrical circuit (e.g., the active load differential amplifier of Figure 3), which is supported by the substrate 105. In one example, the substrate 105 may be formed from a semiconductor material (e.g., silicon, CVD diamond, GaN, etc.), and the fabrication process may use a photolithographic process to form a pattern at the surface 104 of the substrate 105. In some cases, an insulator layer 132 (e.g., silicon dioxide (SiO₂) may be deposited on the surface of the substrate prior to the photolithography process. During the fabrication process, one or more layers of materials may be deposited over and/or etched from the surface 104 of the substrate to form the transistors 110, 120, 130, 140, 150. For example, the gate of the transistors 110, 120, 130, 140, and 150 may be formed by depositing and/or etching one or more layers at the surface 104 of the substrate 105.

More specifically, and in the example shown in Figure 2A, the gate 112 of transistor 110 may be formed by depositing an insulator 132 at the surface of the substrate 105, a piezoelectric layer 124 above the insulator 132, and a metal layer 122 (e.g., the gate contact) above the piezoelectric layer 124. The piezoelectric layer 124 may include one or more piezoelectric materials including crystals, such as aluminum nitride (AlN), zinc oxide (ZnO), lead zirconate titanate (PZT), barium titanate (BaTiO3), polymers, such as polyvinylidene fluoride (PVDF), ferroelectrets, such as polymer foams, ceramics having a perovskite tungsten -bronze structure or a ferroelectret comprising a cellular polymer structure, and/or any other suitable material or material combination. In the transistors 110, 120, 130, 140 formed over the flexible diaphragm 107, the piezoelectric layer may be chosen to produce an electric charge on the gate of the corresponding transistor that is related to a pressure applied to the diaphragm. For example, the piezoelectric material may be chosen based on one or more characteristics of the particular sense die 100, 160, one or more characteristics of the piezoelectric material (e.g., relative dielectric constant, dielectric dissipation factor, Curie point, electromechanical coupling factor, piezoelectric charge constant, piezoelectric voltage constant, Young's modulus, longitudinal, thickness and/or planar frequency constants, density, and/or mechanical quality factor), the amount of piezoelectric material deposited in the piezoelectric layer, and/or the shape/orientation of the piezoelectric layer. In some cases, the piezoelectric material may be deposited using a sputtering process and/or other deposition technique.

In the example shown in Figure 1A, the gate of the transistors may be formed by depositing a metal layer 126 above insulator layer 132 at the surface 104 of the substrate. In some cases, the piezoelectric layer 124 may be deposited directly above the substrate 105, such as in a thin-film transistor (TFT). In some cases, the piezoelectric layer 124 may be deposited above the metal layer 126, and another metal layer 122 may be deposited above the piezoelectric layer 124. In such cases, the metal layers 122 and 126 and the piezoelectric layer 124 may form a piezoelectric capacitor structure at the gate 112. The metal layers provide electrical connections to the transistor 110. In some cases, a transistor 150, located laterally adjacent to the diaphragm 107, may not include a piezoelectric layer 124, as shown in Figures 1A and 2A. In other cases, the transistor 150 may include a piezoelectric layer 124, as shown in Figure 1B.

In some instances, after the transistors 110, 110, 120, 130, 140, 150 are formed above the surface 104 of the substrate, the flexible diaphragm 107 is formed. The diaphragm 107 may be formed by, for example, creating a cavity in the substrate opposite to the surface 104 by etching, or another similar method of forming a cavity 180. The cavity 180 may be exposed, as in Figures 1A and 1B, so that the sense die 100 may be configured to sense a pressure applied at the surface 104, surface 111, or both (e.g., a differential pressure between the pressure applied at the surface 104 and the pressure applied at the surface 111). In other cases, such as in Figures 2A and 2B, the cavity 180 may be sealed. For example the sealed cavity 180 may be formed by securing a second substrate 170 using an adhesive 175 (e.g., an adhesive tape, an adhesive paste, an epoxy, a resin, etc.) to the surface of the substrate opposite to the surface 104. The sealed cavity 180 may enclose an area at a specified pressure (e.g., a vacuum) and may be used as a reference pressure when sensing the pressure applied at the surface 104 of the sense die 160. In some cases, such as in Figure 2B, the substrate 105 may be formed from a flexible material, such as a metal foil and/or a plastic, and a cavity may be formed in the additional substrate 170. The flexible substrate 105 may be affixed to the substrate 170 using an adhesive 175 such that one or more of the stress sensitive transistors 110, 120, 130, 140 may be located above the cavity 180. These are just some example configurations for a pressure sensor.

Figure 3 shows a schematic of an illustrative stress sensitive differential amplifier circuit that may be formed on the sense die of Figures 1A, 1B, 2A, and 2B. As discussed above, the sense die 100, 160 may include two or more transistors 310, 320, 330, 340, 350 arranged in an electrical circuit (e.g., a differential amplifier with a passive load, a differential amplifier with an active load, etc.) to sense a pressure applied to the sense die 100, 160. In some cases, the electrical circuit may be a differential amplifier with an active load, such as the active load differential amplifier circuit 300 shown in Figure 3. In other cases, the electrical circuit may be a differential amplifier with a resistive load. While the illustrative circuit 300 shows two P-type MOSFET transistors and two N-type MOSFET transistors, the circuit 300 could include other types of transistors, such as only P-type MOSFET transistors or only n-type MOSFET transistors.

The active load differential amplifier 300 may be designed using matched components, such as transistors 310, 320, 330, 340, 350, which may be produced on the sense dies 100, 160 using the fabrication process discussed above. The matched components provide for a balanced quiescent point, such that the output of the differential amplifier circuit 300 is about V_{D}/2 when no pressure is applied to the sense die 100. In some cases, the transistors 310 and 320 may be arranged as a differential pair 335, the transistors 330 and 340 may be arranged as an active load for the differential pair 335 (e.g., a current mirror 325), and a transistor 350 may be used as a current source to provide a bias current 359 for the active load differential circuit 300. The active load differential circuit 300 may also include one or more input and/or output terminals such as a voltage source terminal 304, an electrical ground terminal 306, one or more reference voltage terminals 337, 339 and an output terminal 367. In some cases, power may be supplied to the active load differential amplifier 300 using the voltage source terminal 304 and the ground terminal 306. In some cases, the voltage source may be used to produce the reference voltage supplied to one or both of the reference voltage terminals 337, 339. In some cases, the reference voltage source(s) and/or the bias voltage source may be converted from the source voltage V_{D} using a circuit included on the sense die, or another circuit provided within a sensor package including the sense die.

In some embodiments, the transistor 350 may be configured to provide the bias current 359 that is proportional to the bias voltage 357 supplied to the gate of the transistor 350. For a balanced circuit, such as the circuit 300, the transistor 350 may provide a balanced current through the transistors 310, 320 of the differential pair 335 via the current mirror 325. For example, the current I₁ 333 flowing through the transistors 310 and 330 may be substantially equal to the current I₂ 343 flowing through the transistors 340 and 350, where the currents I₁ 333 and I₂ 343 are each equal to about one half of the bias current I_{B} 359.

It is contemplated that the active load differential circuit 300 may be configured as a balanced circuit when no pressure is applied to the diaphragm 107 of sense die 100, 160 of Figures 1A, 1B, 2A, or 2B. In such cases, the output voltage V_{O} at the output terminal 367 may be about V_{D}/2 when no pressure is applied. In some cases, one or more compensation elements (e.g. laser trimmable elements) may be provided to help balance the active load differential circuit 300 when no load is applied, but this is not required.

In some cases, the transistors 310, 320, and in some cases (e.g. transistors 330, 340), may be arranged on the flexible diaphragm 107, such that an external pressure applied to the diaphragm 107 may produce a mismatch in the transistors 310, 320, 330, 340. The resulting mismatch of the transistors 310, 320, 330, 340 may, in turn, unbalance the differential amplifier causing an output voltage and/or output current to be produced. In one example, the pressure applied to the flexible diaphragm 107 may cause the piezoelectric material of the transistor gates (e.g., the piezoelectric layer 124) to generate a corresponding electrical charge, which in turn, may cause a variation of the gate voltage on the transistors 310, 320, 330, 340. The relationship between the pressure applied to the diaphragm 107 and the output voltage V_{O} 367 and/or the output current I_{O} 369 may be calculated using one or more characteristics of the piezoelectric layer of the transistors discussed above. The transistor 350, which may be located laterally adjacent to the diaphragm 107, but not on the diaphragm 107, may not be affected by the applied pressure. While in some cases the gate of the transistor 350 may include a piezoelectric layer, as shown in Figures 1B and 2B, the piezoelectric layer may not generate any noticeable electrical charge in response to the applied pressure because the applied pressure may not cause a deflection of the area 109 of the substrate 105 laterally adjacent to the flexible diaphragm 107.

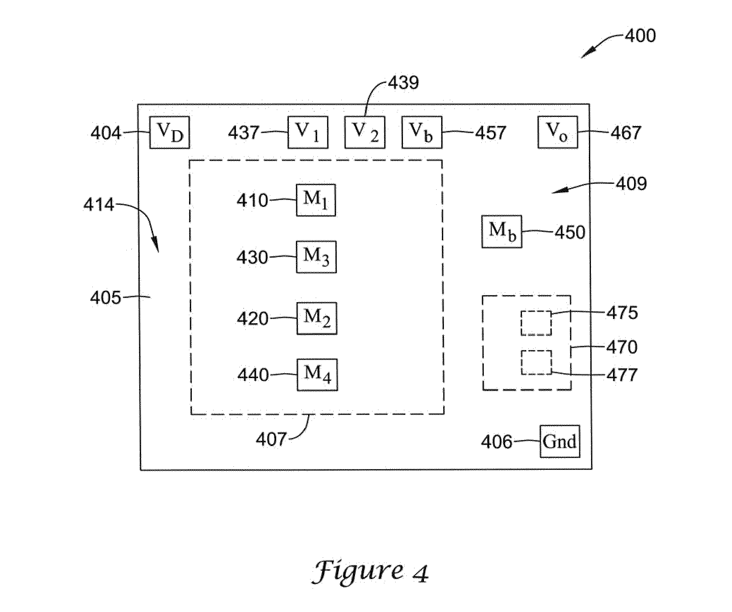

Figure 4 is a schematic top-side view of an illustrative sense die 400 that may represent the sense die 100 of Figures 1A and 1B and/or the sense die 160 of Figures 2A and 2B. In some embodiments, sense die 400 may include a substrate 105 having a flexible diaphragm 407 and an area 409 laterally adjacent to the flexible diaphragm 407. One or more electrical components and/or electrical connections may be formed on a top surface 414 of the substrate 405. In some cases, the diaphragm 407 may be formed by etching out a cavity into the substrate 405 opposite to the surface 414 of the substrate 405, similar to that shown in figures 1A, 1B, and 2A. The sense die 400 may include two or more transistors 410, 420, 430, 440 located over the flexible diaphragm 407, and a transistor 450 located in the area 409 laterally adjacent to the diaphragm 407. The transistors 410, 420, 430, 440 may include a piezoelectric layer within the transistor gates for sensing a deflection of the diaphragm 407 caused by an applied input pressure.

The sense die 400 may include electrically conductive pads 404, 406, 437, 439, 457 and 467 on the top surface of the sense die. For example, the electrically conductive pads may include a power supply connection (e.g., V_{D} 404 and GND 406) and one or more signal paths (e.g., V_{O} 467). In some cases, the substrate may include one or more electrically conductive pads (e.g., V₁ 437, V₂ 439, and V_{b} 457) for one or more other voltages used with the active load differential amplifier 300 of Figure 3. In some cases, a circuit area 470 may be located in the area 409 laterally adjacent to the flexible diaphragm 407. For example, the circuit area 470 may include one or more electrical components 475 to produce one or more of the reference voltages (e.g., V₁, V₂, and V_{b}) from the power supply voltage V_{D} 404.

In some cases, the circuit area 470 may include one or more electrical components 477 for signal conditioning of an output signal (e.g., V_{O}). Although not shown, the sense die 400 may include electrical traces on the surface 414 of the sense die 400 or within the substrate 405 that provide electrical connections between the various electrically conductive pads 404, 406, 437, 439, 457 and 467, the one or more transistors 410, 420, 430, 440, and 450, and/or the one or more components in the circuit area 470. In one example, traces may be used to form electrical connections between the conductive pads V_{D} 404 , GND 406, V₁ 437, V₂ 439, V_{b} 457, or V_{O} 467and the pressure sensing elements for form the active load differential amplifier (e.g., the transistors 410, 420, 430, 440, and 450). In some cases, the traces may be incorporated into the substrate (e.g., p-type doping on an n-type substrate, or an n-type doping of a p-type substrate) and/or may include metal leads on the surface of the substrate, or any other suitable material may be used, such as conductive polymers, polysilicon, etc.

As discussed above, the location and/or arrangement of the transistors on the flexible diaphragm 407 may allow for a more pronounced mismatch between components. For example, a pressure applied the diaphragm 407 may produce an opposite sign strain at the center of the flexible diaphragm 407 when compared with the strain at the edge of the diaphragm 407. Transistors positioned toward the center of the diaphragm 407 (e.g., transistors 420 and 430) may experience strain opposite to the strain experienced by the transistors positioned near an edge of the diaphragm 407 (e.g., transistors 410 and 440). To help increase the effect of pressure differential between the center and the edge of the diaphragm 407, one transistor "M1" of the differential pair 325 of Figure 3 (e.g., transistor 410 in Figure 4) may be located near the edge of the diaphragm 407, and the other transistor "M2" of the differential pair 325 of Figure 3 (e.g., transistor 420 in Figure 4) may be located near the center of the diaphragm 407. Similarly, one transistor "M4" forming the active load pair 335 in Figure 3 (e.g., the transistor 440) may be located near the edge of the diaphragm 407, and the other transistor "M3" of the differential pair 325 (e.g., transistor 430) may be located near the center of the diaphragm 407.

In other cases, transistor "M1" of the differential pair 325 of Figure 3 (e.g., transistor 410 in Figure 4) may be located near the center of the diaphragm 407, and the other transistor "M2" of the differential pair 325 of Figure 3 (e.g., transistor 420 in Figure 4) may be located near the edge of the diaphragm 407. Similarly, transistor "M4" forming the active load pair 335 in Figure 3 (e.g., the transistor 440) may be located near the center of the diaphragm 407, and the other transistor "M3" of the differential pair 325 (e.g., transistor 430) may be located near the edge of the diaphragm 407.

In yet other cases, transistor "M1" of the differential pair 325 of Figure 3 (e.g., transistor 410 in Figure 4) may be located near the center of the diaphragm 407, and the other transistor "M2" of the differential pair 325 of Figure 3 (e.g., transistor 420 in Figure 4) may be located near the edge of the diaphragm 407. Transistor "M4" forming the active load pair 335 in Figure 3 (e.g., the transistor 440) and transistor "M3" of the differential pair 325 (e.g., transistor 430) may both be in area 409 laterally adjacent to the flexible diaphragm 407. These are just some example placements for transistors M1, M2, M3 and M4.

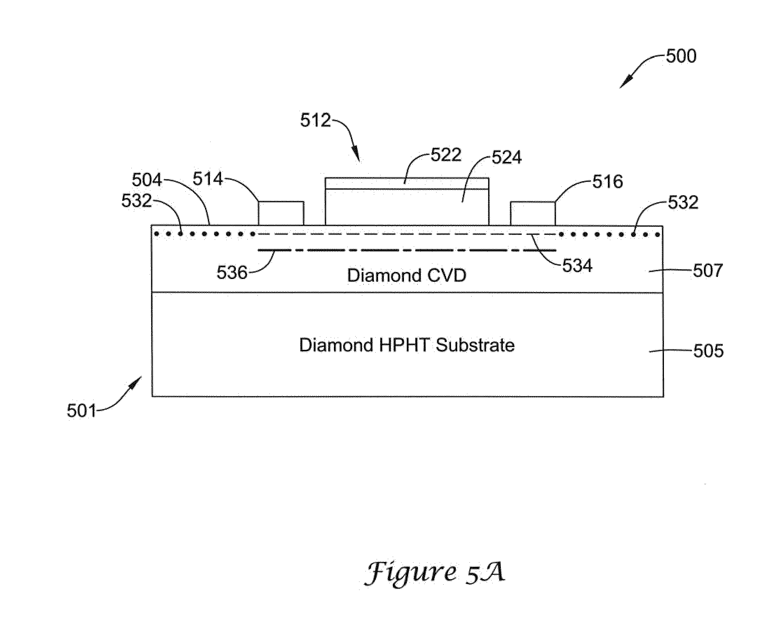

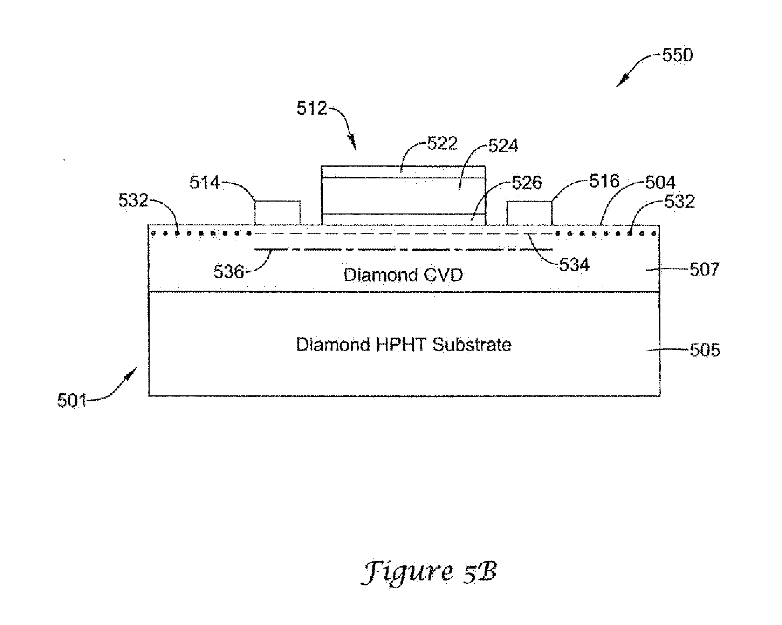

Figures 5A and 5B show illustrative transistor structures 500, 550 formed on a diamond substrate 505 that may be used in the illustrative sense die of Figures 1A, 1B, 2A, 2B, and 4. In some cases, the transistor formed on the diamond substrate may be one of a metal-oxide-semiconductor field effect transistor (MOSFET), a metal-insulator-semiconductor field-effect transistor (MISFET), a high-hole mobility transistor (HHMT), or a metal semiconductor field effect transistor (MESFET). These are just some examples. Some advantages of diamond semiconductors may include stability in a fluid environment, high thermal conductivity, and a high electric-field breakdown voltage. When provided, the diamond transistor 500, 550 may be formed on a substrate 501 having one or more layers 505, 507. For example, the substrate 501 may be formed from a first layer (e.g. the HPHT diamond layer 505) and a second substrate layer (e.g., the CVD diamond layer 507) deposited and/or formed above the first layer 505. The first substrate layer 505 may be formed from a diamond material (e.g., natural diamond, high-pressure high-temperature synthesis (HPHT) diamond, CVD diamond) having a single crystal structure or a poly-crystalline structure. In some cases, the first substrate layer 505 may be another material (e.g., silicon carbide) having a smooth surface upon which the single crystal diamond (e.g., CVD diamond) layer 507 may be grown and/or deposited.

In some cases, the CVD diamond substrate 507 may be coated with an oxygen passivation layer 532 and/or a hydrogen passivation layer 534. The oxygen passivation layer 532 and/or hydrogen passivation layer 534 may provide a smooth surface on the surface 504 of the CVD diamond 507 to facilitate the deposition of one or more layers of material, such as to form a transistor and/or other electrical component structure. The oxygen passivation layer 532 may be deposited using one or more methods, such as the method described in U.S. Patent No. 5,750,898 to Kurtz et al., entitled "Passivation/patterning of PZR diamond films for high temperature transducer operability", which is incorporated herein by reference in its entirety. Kurtz et al. describes a method of placing the diamond substrate 501 into a reactor set substantially below a temperature at which diamond oxidizes and evacuating the reactor to substantially remove all oxygen from the reactor. The temperature of the reactor may be increased to a predetermined temperature so that an oxygen passivation layer 532 is then deposited over the diamond film. In some cases, the oxygen passivation layer may be etched or otherwise patterned, such that one or more electrical components and/or electrical pathways may be formed at the surface 504 of the substrate 501. For example, the remaining oxygen passivation layer 532 may provide electrical isolation of the one or more electrical components and/or electrical pathways formed on the surface 504 of the diamond substrate 501.

The hydrogen passivation layer 534 may be formed over the exposed surface of the CVD diamond substrate 507 to provide a hole accumulation layer that includes a large number of hole carriers. In an example described by Landstrass et al. in "Hydrogen Passivation of Electrically Active Defects in Diamond", published in Applied Physics Letters, May (1989), incorporated herein by reference in its entirety, the hydrogen passivation layer 534 at the surface 504 of the diamond substrate 507 is formed using a hydrogen plasma. The hydrogen passivation layer 534 may have a reduced resistivity (e.g., about 10⁵ ohm cm) from the expected high resistivity of the diamond crystal (e.g., about 10¹⁶ ohm cm) and may be used as a channel in a field effect transistor (FET), such as the transistor 500, 550. In some cases, a two dimensional hole gas (2DHG) layer 536 may form near the interface between the hydrogen passivation layer 534 and the CVD semiconductor layer 507. The 2DHG layer may help hole movement parallel to the surface 504 of the substrate 501.

The transistor 500, 550 may be formed on the surface of the CVD diamond substrate 507 by forming a gate 512, a source 514 and a drain 516. For example, the source 514 and drain 516 may be formed at the surface of the CVD diamond substrate 507 over the hydrogen passivation layer 534 by depositing a metal (e.g., titanium, aluminium, gold, etc.) or other conductor to form the ohmic electrical connection for the source 514 and drain 516, respectively. The gate 512 may include a piezoelectric layer 524, such as the piezoelectric layer 124 discussed above. The piezoelectric layer 524 may be deposited directly over the hydrogen passivation layer 534 to form a HHMT 500 (see Figure 5A), over a metal layer 526 above the hydrogen passivation layer 534 to form the MESFET 550 (see Figure 5B), or over an insulation layer 132, such as aluminum oxide (Al₂O₃), above the hydrogen passivation layer 534 to form a MOSFET or MISFET. In some cases, a metal layer 522 may be deposited above or below the piezoelectric layer 524, and may be patterned to facilitate an electrical connection to the gate 512 of the transistor 500, 550.

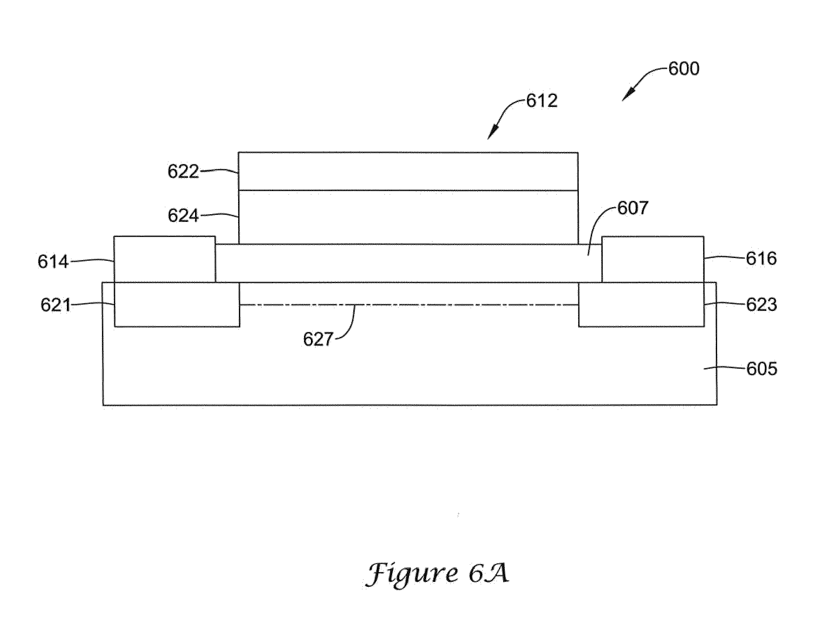

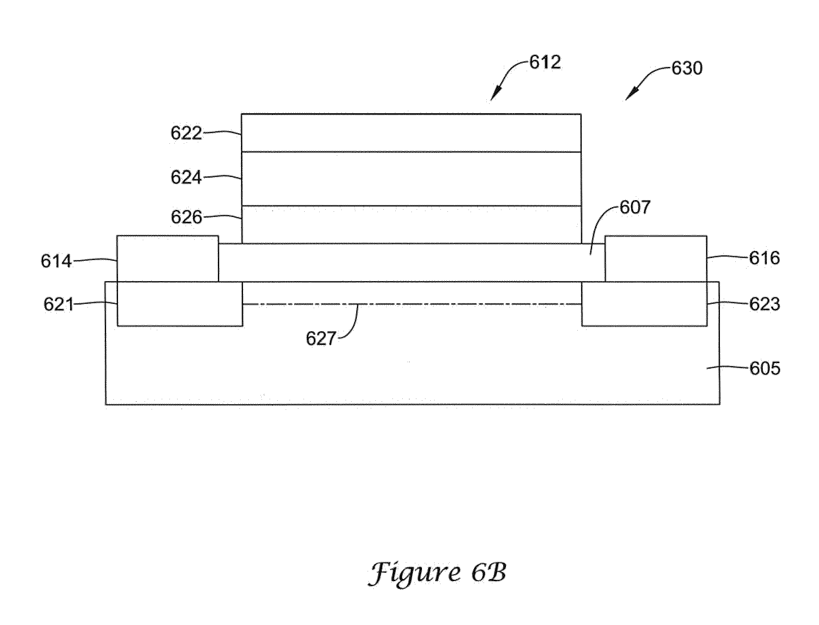

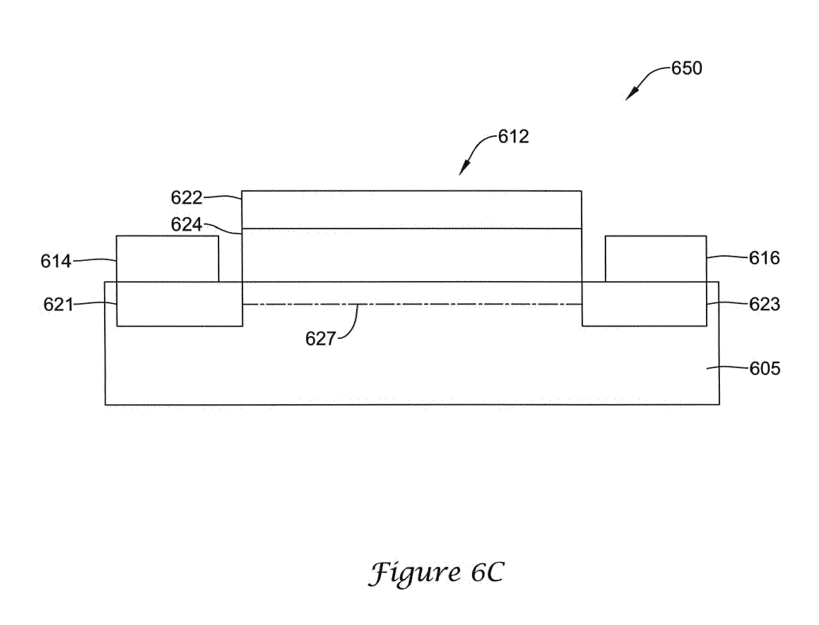

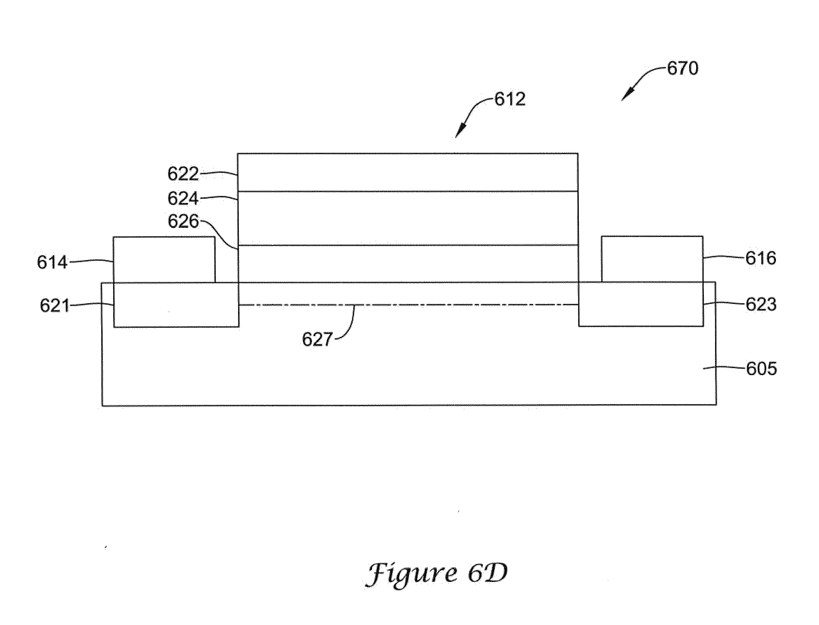

Figures 6A, 6B, 6C and 6D show illustrative metal-oxide-semiconductor field effect transistor (MOSFET) structures 600, 630, and illustrative (MESFET) transistor structures 650, 670 formed on a semiconductor substrate that may be used in the illustrative sense dies of Figures 1A, 1B, 2A, 2B, and 4. The illustrative transistors 600, 630, 650, 670 include a gate 612, a source 614 and a drain 616 formed on a substrate 605. The substrate 605 may include two or more regions 621, 623 that may be doped with a p-type material in an n-type substrate 605, or doped with an n-type material in a p-type substrate 605. As discussed above, the substrate 605 may include one or more semiconductor materials, such as silicon, germanium, diamond, silicon carbide (SiC), gallium nitride (GaN), gallium arsenide (GaAs), sapphire, diamond, indium phosphide (InP) and the like. To form a MOSFET, a gate insulator layer 607, such as SiO₂, may be deposited at a surface of the substrate 605 and may be etched or otherwise patterned to form one or more transistors 600, 630. In some cases, contacts for the source 614 and the drain 614 may be formed by depositing a metal layer, or other conductive layer, above the doped regions 621, 623, respectively. During operation, when a sufficient voltage is generated at the gate, a channel 627 may be formed between the doped regions 621, 623 to allow current flow between the source 614 and the drain 616.

The gate 612 of the MOSFETs 600, 630 of Figures 6A and 6B may be formed by depositing a piezoelectric layer 624, such as the piezoelectric materials discussed above, over the gate insulator layer 607, and in some cases, a metal layer 622 over the piezoelectric layer 624. In some cases, and as best shown in Figure 6B, a metal layer 626 may be provided between the piezoelectric layer 624 and the gate insulator layer 607, forming a piezoelectric capacitor within the gate 612, but this is not required.

Similarly, the gate 612 of the MESFETs 650, 670 of Figures 6C and 6D may be formed by depositing a piezoelectric layer 624, such as the piezoelectric materials discussed above, over the substrate 605 between the doped regions 621, 623, and a metal layer 622 over the piezoelectric layer 624. In some cases, and as best shown in Figure 6D, a metal layer 626 may be provided between the piezoelectric layer 624 and the substrate 605, forming a piezoelectric capacitor within the gate 612, but this is not required.

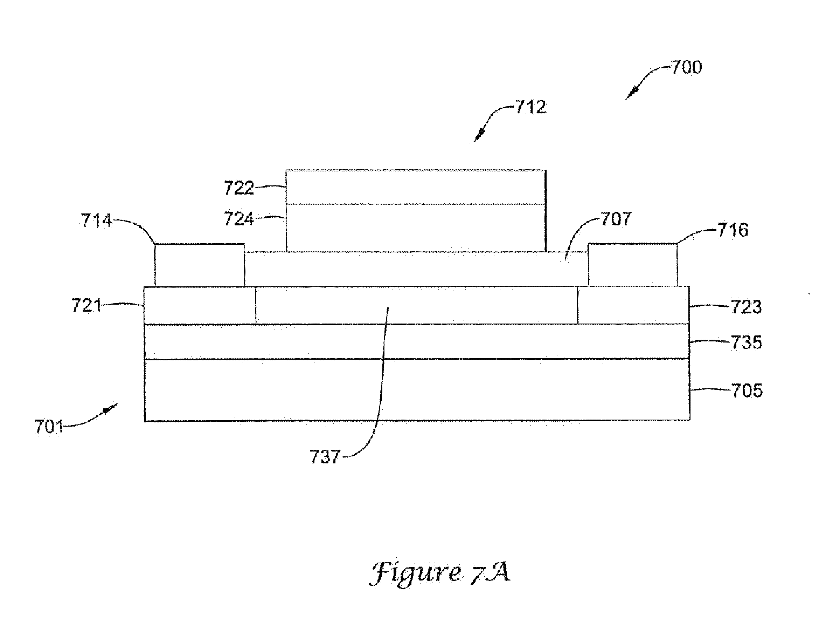

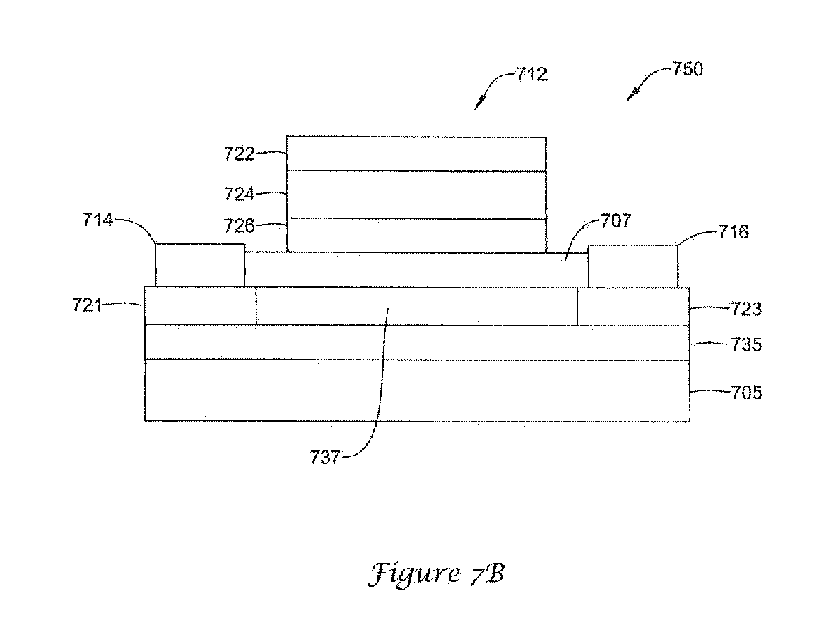

Figures 7A and 7B show illustrative metal-oxide-semiconductor field effect transistor (MOSFET) structures 700, 750 formed on a silicon-on-insulator (SOI) substrate that may be used in the illustrative sense dies of Figures 1A, 1B, 2A, 2B, and 4. In one example, SOI technology may provide advantages over bulk silicon CMOS processing. For example, SOI transistors may provide higher speed, lower power dissipation, high radiation tolerance, lower parasitic capacitance, lower short channel effects, higher sub-threshold voltage swing, and manufacturing compatibility with existing bulk silicon CMOS technology. One or more techniques may be used to produce the SOI substrate, including using homo-epitaxial techniques, heteroepitaxial techniques, recrystallization techniques, such as laser recrystallization, e-beam recrystallization and zone-melting recrystallization.

The substrate 701 may include a silicon oxide layer 735 located between two layers of silicon 737 and 705. Silicon layer 705 may correspond to a bulk silicon substrate, upon which the silicon oxide layer 735 was grown. Silicon layer 737 may be a thin silicon epitaxial layer grown on the silicon oxide layer 735.

When a transistor is formed, the silicon layer 737 may include two or more doped regions, such as doped regions 721 and 723. The silicon layer 737 may be doped with a p-type material, and the doped regions 721 and 723 may be doped with an n-type material to form an NPN transistor. Similarly, to form a PNP transistor, the silicon layer 737 may be doped with an n-type material, and the doped regions 721 and 723 may be doped with a p-type material. The gate 712 of the MOSFETs 700, 750 may be formed by depositing a piezoelectric layer 724, such as the piezoelectric materials discussed above, over a gate insulator layer 707, and in some cases a metal layer 722 over the piezoelectric layer 724 (see Figure 7A). In some cases, a metal layer 726 may be provided between the piezoelectric layer 724 and the gate insulator layer 707, forming a piezoelectric capacitor within the gate 712 (see Figure 7B). In some cases, electrical contact is made to the source 714 and the drain 716 by depositing a metal or other conductive layer on the doped regions 721, 723, respectively. During transistor operation, when a sufficient voltage is generated at the gate, a channel may be formed between the doped regions 721, 723, which allows current to flow between the source 714 and the drain 716.

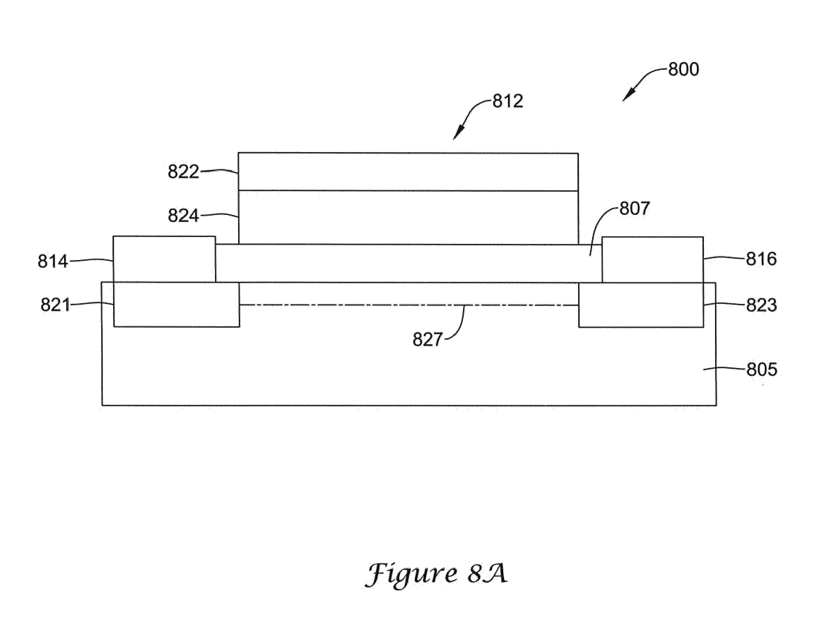

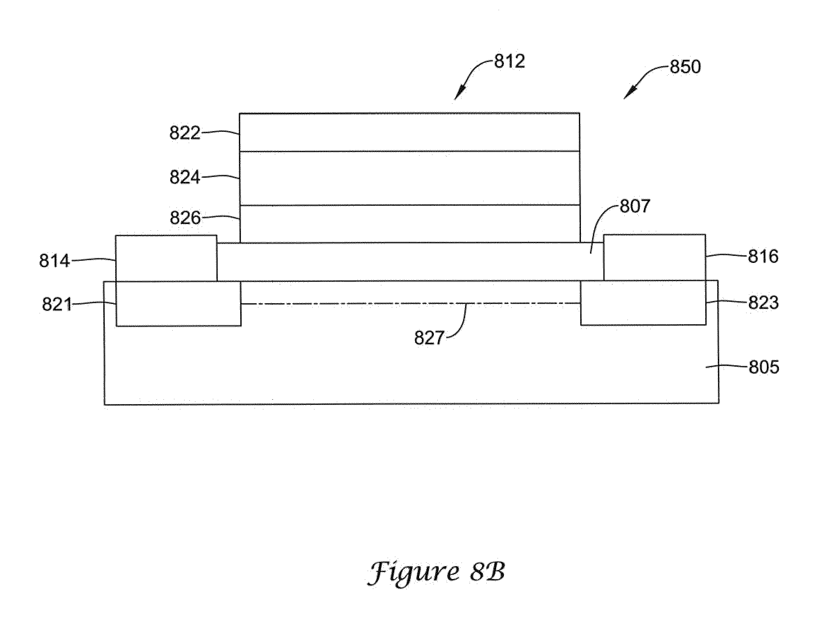

Figures 8A and 8B show illustrative metal-oxide-semiconductor field effect transistor (MOSFET) structures 800, 850 formed on a silicon carbide (SiC) substrate that may be used in the illustrative sense dies of Figures 1A, 1B, 2A, 2B, and 4. The transistors 800, 850 include a gate 812, a source 814 and a drain 816 formed on a SiC substrate 805. Some advantages of using silicon carbide substrates may include increased power density per gate width (e.g., about 8 times that of a silicon substrate), high operation temperature capability, and improved heat conductivity. In some cases, the substrate 805 may be formed from a n-type silicon carbide material, for improved electron mobility. The substrate 805 may be manufactured using epitaxial layers on a semi-insulating substrate to minimize parasitic capacitance. The transistors 800, 850 may include two or more doping regions 821, 823. For example, the silicon carbide substrate 805 may be doped to create a p-type material, and the doped regions 821 and 823 may be doped to create an n-type material to form an NPN transistor.

In some cases, electrical connections may be made to the source 814 and the drain 816 by depositing a metal or other conductive layer above the doped regions 821, 823, respectively. The gate 812 of the MOSFETs 800, 830 may be formed by depositing a piezoelectric layer 824, such as the piezoelectric materials discussed above, over a gate insulator layer 807, and in some cases, a metal layer 822 over the piezoelectric layer 824 (see Figure 8A). In some cases, a metal layer 826 may be deposited between the piezoelectric layer 824 and the gate insulator layer 807 (see Figure 8B), forming a piezoelectric capacitor within the gate 812. During operation, when a sufficient voltage is generated at the gate, a channel 827 may be formed between the doped regions 821, 823 to allow current flow between the source 814 and the drain 816.

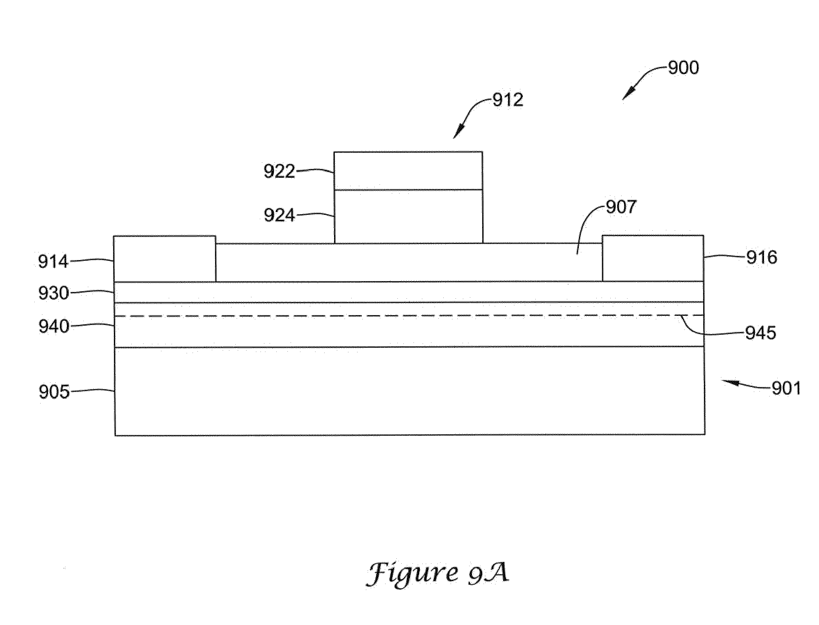

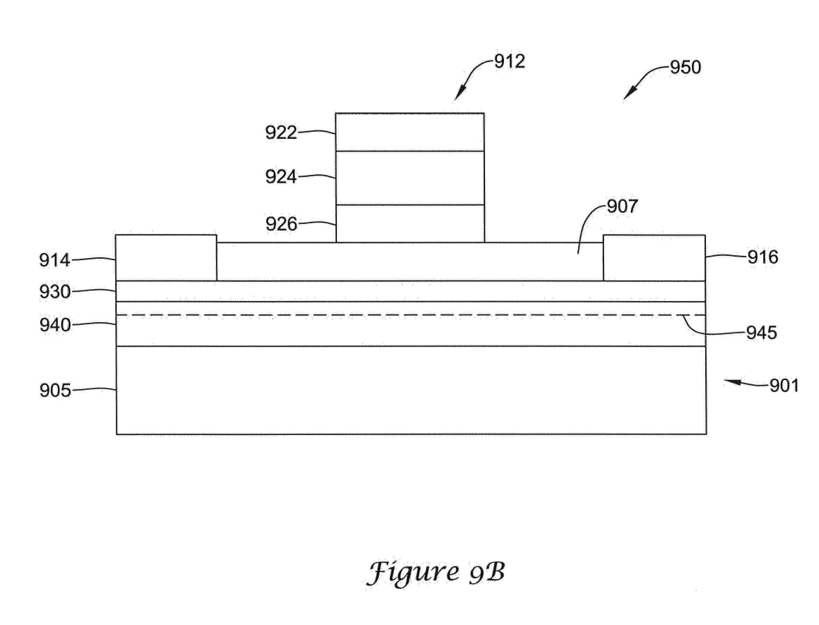

Figures 9A and 9B show illustrative high electron mobility transistors (HEMTs) 900, 950 formed on a substrate 901 that may be used in the illustrative sense die of Figures 1A, 1B, 2A, 2B, and 4. The illustrative transistors 900, 950 include a source contact 914, a drain contact 916 and a gate 912 formed over substrate 901. The substrate 901 may include one or more layers, including a base substrate 905, a gallium nitride (GaN) layer 940, and an aluminum gallium nitride (AlGaN) layer 930. In the example shown, the GaN layer 940 may be grown above a base substrate 905, such as a silicon substrate. The AlGaN layer 930 may be grown above the GaN layer 940. In some cases, one or both of the GaN layer 940 and the AlGaN layer 930 may be grown using one or more techniques such as metal-organic chemical vapor deposition (MOCVD) or molecular beam epitaxy (MBE).

In some cases, the substrate may be etched to form regions for forming one or more electrical components, electrical pathways, or both. In some cases, electrical connections to the source 914 and the drain 916 may be formed by depositing a metal or other conductive layer directly above the AlGaN layer 930. The gate 912 may be formed over a gate insulating layer 907, such as silicon oxide (SiO₂), deposited above the AlGaN layer 930. In some cases, the gate may be formed directly above the AlGaN layer 930. The gate 912 may be formed by depositing a piezoelectric layer 924, such as the piezoelectric materials discussed above, over the insulator layer 907, and in some cases, a metal layer 922 over the piezoelectric layer 924 (see Figure 9A). In some cases, a metal layer 926 may be deposited between the piezoelectric layer 924 and the insulator layer 907 (see Figure 9B), forming a piezoelectric capacitor within the gate 912. While the GaN substrate may include piezoelectric capabilities, the piezoelectric effect of the substrate 901 may have little effect in sensing a pressure applied to the sense dies 100, 160 of Figures 1A, 1B, 2A, and 2B. The piezoelectric effect of the gallium nitride substrate may influence the two-dimensional electron gas (2DEG) 945 located near the interface between the AlGaN layer 930 and the GaN layer 940 due to stress induced polarization. Therefore, piezoelectric effect also modifies the current flowing through the transistor. Moreover, by including the supplementary piezoelectric layer 924 in the transistor structure, the sensing capabilities are significantly improved.

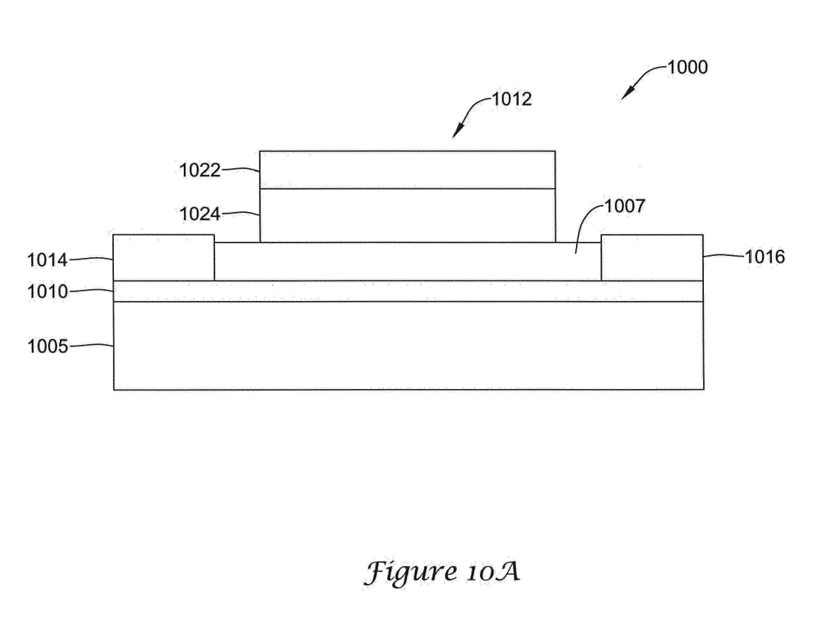

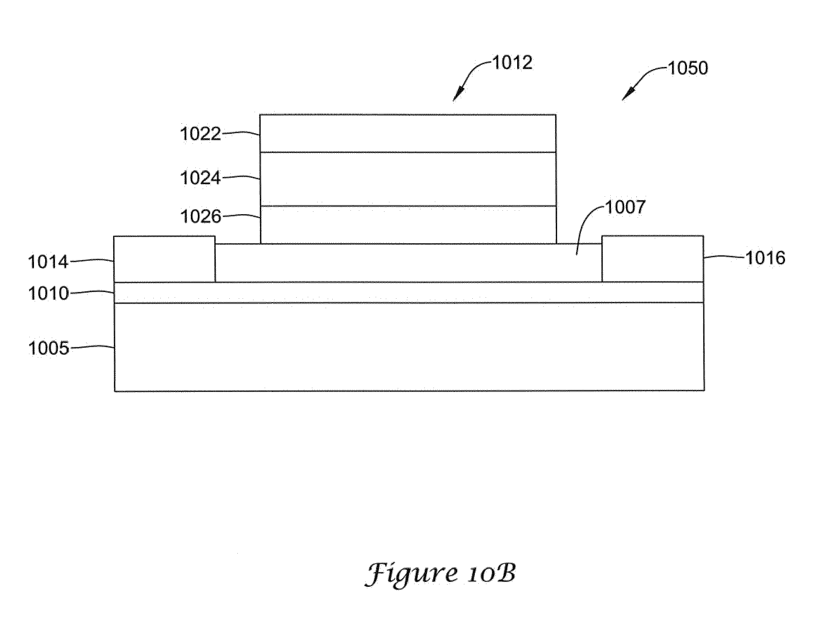

Figures 10A and 10B show illustrative thin-film transistors (TFTs) 1000, 1050 that may be used in the illustrative sense die of Figures 1A, 1B, 2A, 2B, and 4. In some cases, the TFTs may be formed by depositing a thin film of a semiconductor material 1010 above a substrate 1005. The substrate 1005 may include one or more of a metallic foil, a plastic, glass or a semiconductor material. In some cases, the substrate 1005 may be rigid, while in other cases, the substrate 1005 may be flexible. The thin-film semiconductor material 1010 may include one or more semiconductor materials, such as Si, GaAs, GaN, SnO₂, indium oxide (In₂O₃), indium nitride (InN), aluminum indium nitride (AlInN), zinc oxide (ZnO), indium gallium zinc oxide (InGaZnO), polycristaline silicon, amorphous silicon, hydrogenated amorphous silicon (a-Si:H), microcrystalline silicon, or polysilicon and the like. In some cases, the thin film transistor may be an organic field effect transistor (OFET) that includes a semiconductor layer of an organic material (e.g., rubrene, tetracene, pentacene, diindenoperylene, perylenediimides, and tetracyanoquinodimethane (TCNQ), polythiophene, polyfluorene, polydiacetylene, poly 2,5-thienylene vinylene, or poly p-phenylene vinylene (PPV)).

A gate 1012, a source 1014 and a drain 1016 may be formed above the thin film semiconductor material 1010. In some cases, electrically connections may be made to the source 1014 and the drain 1016 by depositing a metal or other conductive layer directly above the thin film semiconductor material 1010. In some cases, the gate 1012 may be formed directly above the thin film semiconductor layer 1010. In some cases, the gate 1012 may be formed by depositing a piezoelectric layer 1024, such as the piezoelectric materials discussed above, over a gate insulator layer 1007, and in some cases, a metal layer 1022 over the piezoelectric layer 1024 (see Figure 10A). In some cases, a metal layer 1026 may be deposited between the piezoelectric layer 1024 and the insulator layer 1007 (see Figure 10B, forming a piezoelectric capacitor within the gate 1012. An example thin-film transistor that includes a piezoelectric layer is described in the U.S. Patent Publication No. 2011/0049579 to Dumitru et al. entitled "THIN-FILM TRANSISTOR BASED PIEZOELECTRIC STRAIN SENSOR AND METHOD", and is incorporated herein by reference in its entirety. Some advantages of using thin film transistors 1000, 1050 for use with the sense dies 100, 160, and 400 of Figures 1A, 1B, 2A, 2B and 4 include providing a packaged sensor with a lower profile, a smaller size, a lighter weight, lower fabrication cost and/or better performance.

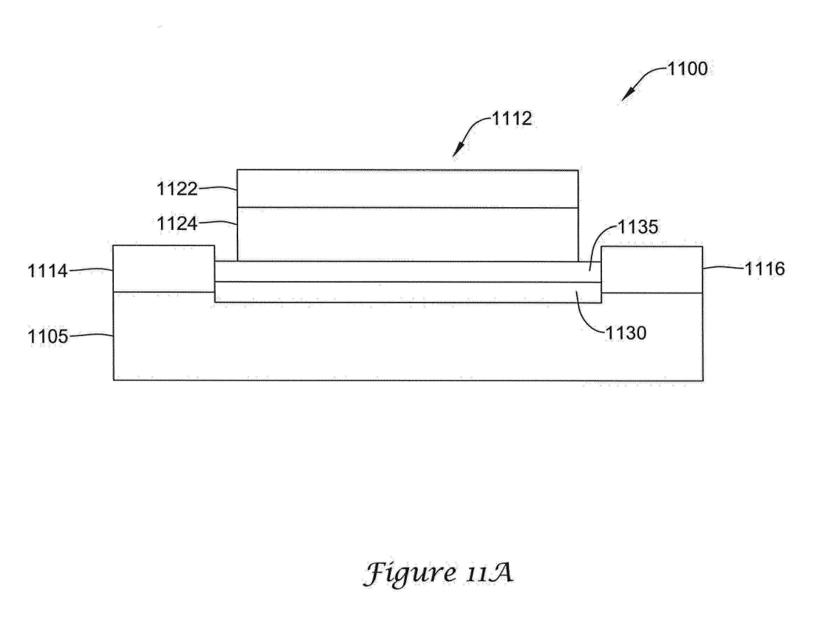

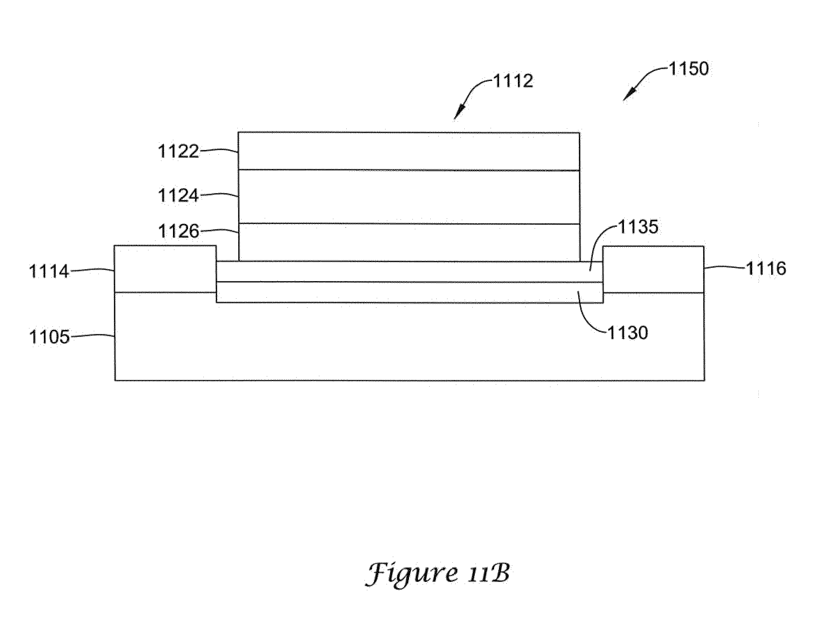

Figures 11A and 11B show illustrative nanowire transistors (NWTs) 1100, 1150 that may be used in the illustrative sense die of Figures 1A, 1B, 2A, 2B, and 4. The transistor 1100, 1150 include a gate 1112, a source 1114, and a drain 1116 formed over a substrate 1105. In an example, the substrate 1105 may be formed from a rigid material, such as high resistivity silicon wafer, a SiC wafer, or another high resistivity rigid material.. In some cases, the substrate 1105 may be formed from a flexible isolator material such as a plastic foil. A nanowire layer 1130 may be provided on the surface of the substrate 1105, such as by printing the nanowire layer 1130 onto the surface of the substrate 1105. In some cases, the nanowire layer 1130 may be aligned on the surface of the substrate 1105 between the source 1114 and the drain 1116 by one or more processes, such as fluid flow through microchannels, using an orientation method using a magnetic field, using a shear force created by the expansion of a blown-bubble film, and/or interactions with chemically patterned surfaces. In some cases, the nanowire layer 1130 may be grown at a specific location on the substrate 1105, such as by depositing nanoparticles of a metal, such as colloidal gold. In some cases, the nanowire layer 1130 may be made of one or more materials, such as silicon, gallium nitride, zinc oxide, carbon nanotubes, and the like. In some cases, the nanowire layer 1130 may be formed of two or more materials, such as a germanium and silicon nanowire. In another example, the nanowire layer 1130 may be grown by another process, such as a vapor solid process, electrochemical deposition, or solution growth. After the nanowire layer 1130 is grown, the gate 1112 may be formed above the nanowire layer 1130. For example, a gate insulator 1135 may be deposited above the nanowire layer 1130, such as a silicon oxide (SiO₂) layer.

In some cases, electrical connections to the source 1114 and the drain 1116 may be formed by depositing a metal or other conductive layer. In some cases, the gate 1112 may be formed by depositing a piezoelectric layer 1124, such as the piezoelectric materials discussed above, over a gate insulator layer 1107, and in some cases, a metal layer 1122 over the piezoelectric layer 1124 (see Figure 11A). In some cases, a metal layer 1126 may be deposited between the piezoelectric layer 1124 and the insulator layer 1107 (see Figure 11B), forming a piezoelectric capacitor within the gate 1112.

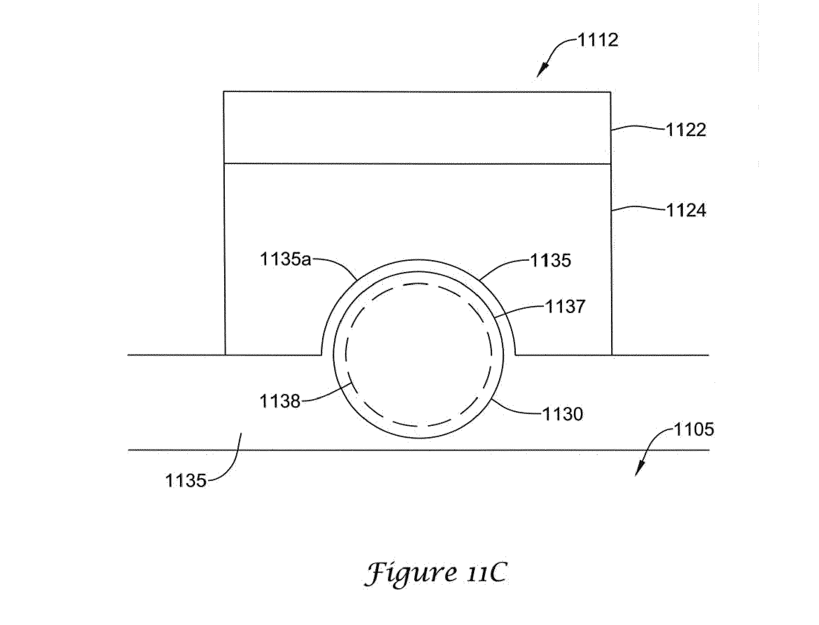

Figure 11C shows a cross-sectional view of an illustrative gate 1112 of the transistor 1100 of Figures 11A. In this example, the gate 1112 may be formed by depositing a silicon oxide layer 1135 above a substrate 1105, such as a p-doped silicon substrate. A nanowire layer 1130 may be grown and/or deposited above the silicon oxide layer 1135. In some cases, the nanowire 1130 may be made of a single material, such as silicon, germanium, a carbon nanotube, or colloidal gold. In other cases, the nanowire 1130 may be formed from two or more materials, such as a germanium and silicon nanotube, that includes a layer of germanium 1137 surrounding a core of silicon 1138. The nanotube 1130 may be aligned to bridge a gap between the source 1114 and the drain 1116 of the transistor 1100. In some cases, another insulator layer 1135A may be deposited above the nanowire 1130 and the first insulator layer 1135. The piezoelectric layer 1124 and the metal gate contact layer 1122 may then be deposited above the insulator 1135A and the nanowire layer 1130 to complete the gate.

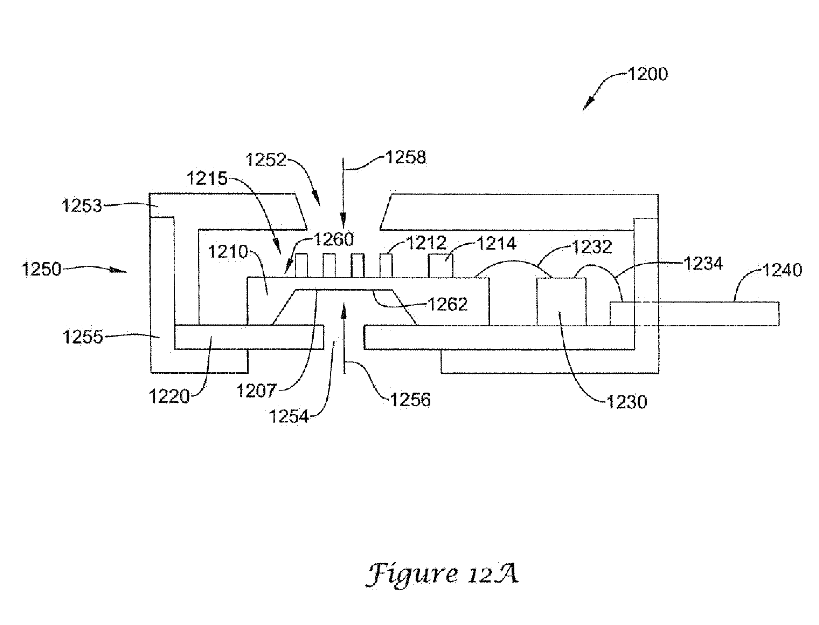

Figure 12A shows a cross-sectional view of an illustrative pressure sensor 1200 including the illustrative sense die 100, 160, and 400 of Figures 1A, 1B, 2A, 2B and 4. In some cases, the pressure sensor 1200 may include a sense die 1210 affixed to a substrate 1220. The sense die 1210 may have one or more transistors 1212 positioned over a flexible diaphragm 1207 and one or more transistors 1214 located on a portion of the sense die 1210 that is laterally adjacent to the diaphragm 1207. The transistors 1212 and the transistors 1214 may be connected to form an electrical circuit, such as the active load differential sensor 300 described above. The sense die 1210 may be located within a cavity 1215 of a housing 1250. In an example, the cavity 1215 may also include one or more other electrical circuits 1230. The electrical circuits 1230 may be configured to, for example, condition an output signal from the sense die 1210. In another example, the electrical circuits 1230 may include components for creating one or more reference voltages, such as the V₁ 337, V₂ 339 and V_{b} 357 voltages discussed above. The electrical circuits on the sense die 1210 may be connected to the one or more electrical circuits 1230 via an electrical connection 1232 (e.g. wire bonds).

The housing 1250 may include a base 1255 and a cover 1253 and one or more electrical contacts 1240 capable of providing an electrical connection from a circuit external to the sensor 1200 and one or more component located within the cavity 1215 of the housing 1250. In some cases, the electrical contacts 1240 may be connected to one or more of the electrical circuits 1230 and/or the sense die 1210 using one or more of the electrical contacts 1232 and 1234. In some cases, the housing 1250 may include one or more openings 1252, 1254 for allowing a pressure to be applied to a surface of the sense die 1210. In one example, the sensor 1200 may be configured to sense a differential pressure between a first pressure 1258 applied to a top surface 1260 of the sense die 1210, and a second pressure 1256 applied to a bottom surface 1262 of the sense die 1210, using the piezoelectric characteristics of the transistors 1212 arranged in an active load differential amplifier configuration. In some cases, the sensor may be configured for sensing one of the first pressure 1258 or the second pressure 1256.

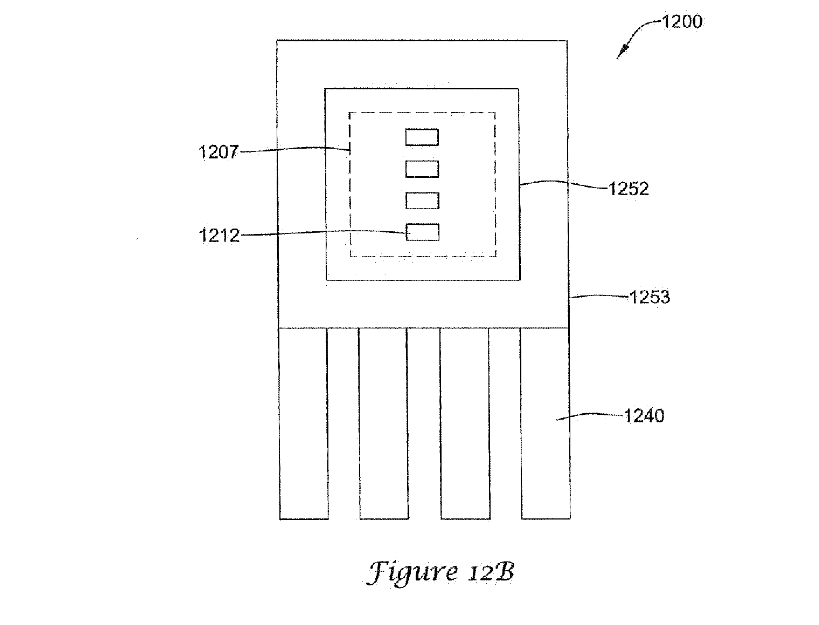

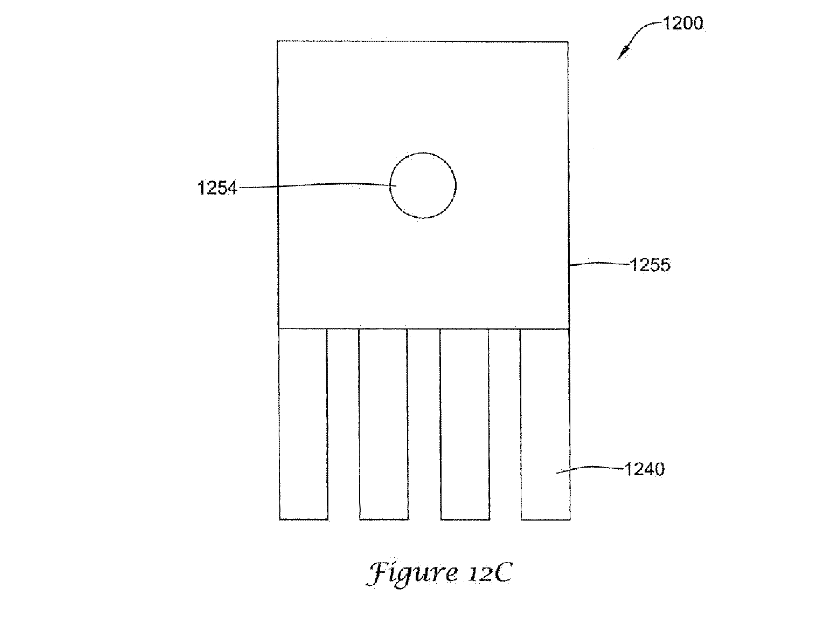

Figures 12B and 12C shows a package view of the illustrative pressure sensor 1200 of Figure 12A. Figure 12B shows a front view of the pressure sensor 1200 and Figure 12C shows a back view of the pressure sensor 1200. In the example shown, the opening 1252 over the top surface 1260 of the sense die 1210 may expose the front surface of the diaphragm 1207 to an externally applied pressure 1258, and the opening 1254 may expose the back surface of the diaphragm 1207 to an externally applied pressure 1256. In some cases, the base 1255 and the cover 1253 of the housing 1250 may form a surface mount technology (SMT) package. In other cases, the base 1255 and/or the cover 1253 of the housing 1250 may form another integrated circuit packaging type, such as a small-outline integrated circuit (SOIC) package, a plastic leaded chip carrier (PLCC) package, a Single In-Line Package (SIP), Dual In-Line Package (DIP), a Ball Grid Array (BGA) package, or any other suitable package type. The base 1255 and/or cover 1253 may be formed using any suitable material including, for example, plastic, polyamide, ceramic, metal, or any other suitable material.

As shown in Figures 12A-12C, the base 1255 may include one or more electrical connections 1240. These electrical connections may include connections for a power supply, ground, and one or more output signals such as a single ended or a differential output signal. More generally, the electrical connections 1240 may be used for transmitting and/or receiving power and/or other signals to/from the sense die 1210. In some cases, the leads 1240 may be formed of metal, but may also be made of any suitable conductive material, such as a conductive polymer.

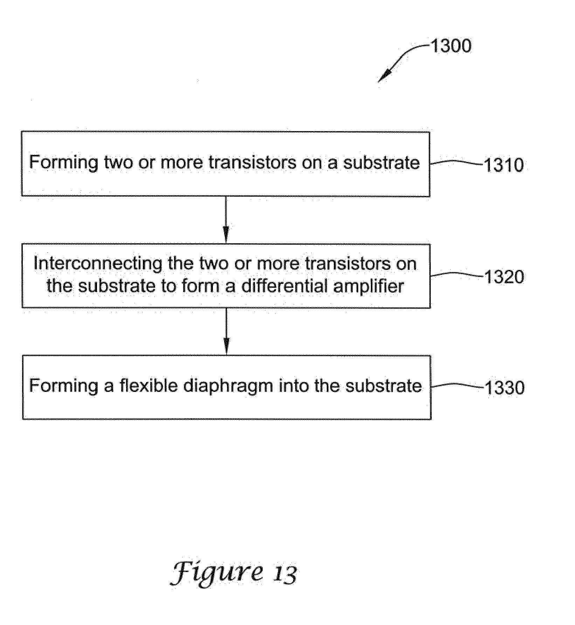

Figure 13 shows an illustrative technique 1300 for manufacturing a pressure sensor having a piezoelectric layer deposited above a semiconductor layer, such as the illustrative pressure sensors of Figures 1A, 1B, 2A, 2B, and 4. At 1310, two or more transistors may be formed on a substrate. In some cases, the substrate includes a semiconductor material, such as silicon, HPHT diamond, GaN, or other suitable material including those discussed above. In another case, a semiconductor layer may be deposited on a substrate, such as a silicon layer deposited on a buried oxide layer, a CVD diamond layer deposited on a HPHT diamond substrate, or a thin film of semiconductor deposited above a substrate such as a metal foil. A piezoelectric layer, and in some cases one or more metal layers, may be deposited above the semiconductor layer to form the transistor gate, source and/or drain, as discussed above.

At 1320, the two or more transistors may be interconnected to form an electric circuit, such as the active load differential amplifier 300 of Figure 3. In some cases, a metal layer may be deposited over the whole surface of the substrate, such as by sputtering aluminum or other metal. A pattern of electrical interconnections may be projected onto the deposited metal layer (e.g., masking) to form a pattern of electrical pathways. The excess metal may be etched or otherwise removed from the substrate to form the electrical pathways (e.g. traces). At 1330, a flexible diaphragm, such as the diaphragm 107 of Figure 1A, may be formed into the substrate. In some cases, the flexible diaphragm may be formed on a surface opposite to the surface upon which the transistors are formed, wherein the diaphragm is capable of deforming when a suitable pressure is applied. For example, a cavity may be formed, such as by etching the substrate, to form the diaphragm in the substrate. In some cases, one or more transistors may be formed on the substrate laterally adjacent to the diaphragm, such as the transistor 150 of Figure 1A or the transistor 450 of Figure 4. The interconnecting step 1320 may include interconnecting the one or more transistors that are laterally adjacent to the diaphragm with the transistors on the diaphragm to form an electrical circuit, such as the active load differential amplifier of Figure 3. When the diaphragm deforms in response to an applied input pressure, the piezoelectric layer may generate an electric charge at the gate of the transistors that are located on the diaphragm. This electric charge may modulate the current that is passing through the corresponding transistors, which may cause the differential amplifier to produce an output that is representative of the applied input pressure.

Having thus described several illustrative embodiments of the present disclosure, those of skill in the art will readily appreciate that yet other embodiments may be made and used within the scope of the claims hereto attached. It will be understood that this disclosure is, in many respects, only illustrative. Changes may be made in details, particularly in matters of shape, size, and arrangement of parts without exceeding the scope of the disclosure. The disclosure's scope is, of course, defined in the language in which the appended claims are expressed.

## Claims

1. A pressure sensor comprising:
a substrate having a flexible diaphragm;
a differential amplifier including two or more transistors formed on the flexible diaphragm, each transistor including a gate, a source and a drain, wherein each transistor includes a semiconductor layer and a piezoelectric layer, wherein the piezoelectric layer modulates an electric charge on the gate of the corresponding transistor which is related to an input pressure applied to the flexible diaphragm.

2. The pressure sensor of claim 1, wherein the two or more transistors are metal-oxide-semiconductor field-effect transistors (MOSFETs) including a semiconductor layer that includes at least one of silicon (Si), silicon carbide (SiC), silicon on insulator (SOI), diamond, gallium nitride (GaN), and gallium arsenide (GaAs).

3. The pressure sensor of claim 1, wherein the two or more transistors are high electron mobility transistors (HEMTs) that include a semiconductor layer of gallium nitride (GaN).

4. The pressure sensor of claim 1, wherein the two or more transistors are high hole mobility transistors (HHMTs) that include a semiconductor layer of diamond.

5. The pressure sensor of claim 1, wherein the two or more transistors are organic field effect transistors (OFETs) that include a semiconductor layer of an organic material.

6. The pressure sensor of claim 1, wherein the two or more transistors are thin film transistors (TFTs) including a semiconductor layer having at least one of Zinc oxide (ZnO), Indium gallium zinc oxide (InGaZnO), polycristaline silicon, amorphous silicon, hydrogenated amorphous silicon (a-Si:H), microcrystalline silicon, or polysilicon.

7. The pressure sensor of claim 1 wherein the two or more transistors are nanowire (NW)-FETs including a piezoelectric layer, a semiconductor layer, and a nanowire between the piezoelectric layer and the semiconductor layer, the nanowire including at least one of a carbon nanotube or a germanium and silicon nanowire.

8. The pressure sensor of claim 1, wherein the piezoelectric layer includes at least one of aluminum nitride (AlN), zinc oxide (ZnO), lead zirconate titanate (PZT), barium titanate (BaTiO3), or polyvinylidene fluoride (PVDF) or at least one of a ceramic having a perovskite tungsten - bronze structure or a ferroelectric having a cellular polymer structure.

9. A pressure sensor comprising:
a flexible diaphragm having a diamond layer;
a differential amplifier including two or more transistors on the diamond layer, each transistor having a gate, a source and a drain, wherein each transistor includes a piezoelectric layer supported by the diamond layer, wherein the piezoelectric layer provides an electric charge on the gate of the corresponding transistor, the electric charge being related to an input pressure applied to the flexible diaphragm.

10. The pressure sensor of claim 9, wherein the diamond layer includes a chemical vapor deposition (CVD) diamond layer, wherein the CVD diamond layer includes a two-dimensional hole gas layer formed by hydrogen passivation of a surface of the CVD diamond layer.

11. The pressure sensor of claim 9, wherein the piezoelectric layer includes at least one of aluminum nitride (AlN), zinc oxide (ZnO), lead zirconate titanate (PZT), barium titanate (BaTiO3), or polyvinylidene fluoride (PVDF).

12. The pressure sensor of claim 9, wherein the piezoelectric layer includes at least one of a ceramic having a perovskite tungsten - bronze structure or a ferroelectret having a cellular polymer structure.

13. The pressure sensor of 9, wherein the two or more transistors are Metal semiconductor field effect transistors (MESFETs).

14. The pressure sensor of 9, wherein the two or more transistors are high hole mobility transistors (HHMTs).

15. The pressure sensor of 9, wherein the two or more transistors are metal-oxide-semiconductor field-effect transistors (MOSFETs).
